# FASCICULE DE BREVET EUROPEEN

(11) **EP 2 111 477 B1**
(45) Date de publication et mention de la délivrance du brevet: **13.03.2019**
(21) Numéro de dépôt: 08761766.8
(22) Date de dépôt: 16.01.2008
(51) Int. Cl.: C23C 14/22, C23C 14/24, C23C 14/34, C23C 14/35, C23C 14/56, H01J 37/32, H01J 37/34

(54) **PROCÉDÉ DE REVÊTEMENT D'UN SUBSTRAT, INSTALLATION DE MISE EN OEUVRE DU PROCÉDÉ ET DISPOSITIF D'ALIMENTATION EN MÉTAL D'UNE TELLE INSTALLATION**
VERFAHREN ZUR BESCHICHTUNG EINES SUBSTRATS, AUSRÜSTUNG ZUR ANWENDUNG DIESES VERFAHRENS UND METALLZUFUHRVORRICHTUNG FÜR EINE SOLCHE AUSRÜSTUNG
METHOD FOR COATING A SUBSTRATE, EQUIPMENT FOR IMPLEMENTING SAID METHOD AND METAL SUPPLY DEVICE FOR SUCH EQUIPMENT

(30) Priorité: 16.01.2007 EP 07290054
(43) Date de publication de la demande: 28.10.2009
(73) Titulaire: ArcelorMittal, 1160 Luxembourg (LU)
(72) Inventeur: CHALEIX, Daniel, F-57420 Verny (FR); JACQUES, Daniel, F-57100 Thionville (FR); SPONEM, Florent, F-57190 Florange (FR)
(74) Mandataire: Lavoix
(86) Numéro de dépôt international: PCT/FR2008/000046
(87) Numéro de publication internationale: WO 2008/107538

(56) Documents cités:
- JP-A- 63 050 472
- US-A- 5 135 817
- US-A- 5 230 923

## Description

La présente invention concerne un procédé de revêtement de substrat en défilement, plus particulièrement destiné au revêtement de bandes d'acier par des couches à base d'éléments métalliques, tels que le magnésium par exemple, sans pour autant y être limitée.

On connaît différents procédés permettant de déposer sur un substrat en défilement, telle qu' une bande d'acier, des revêtements métalliques composés d'une couche de métal, de plusieurs couches successives de différents métaux, ou bien encore d'alliages métalliques. Parmi celles-ci, on pourra citer la galvanisation au trempé à chaud, l'électrodéposition ou bien encore les différents procédés de dépôt sous vide (sputtering magnétron, évaporation par effet joule, par bombardement électronique et par plasma auto-induit encore appelé SIP).

Les procédés de dépôt sous vide présentent l'avantage d'être respectueux de l'environnement et de permettre de déposer virtuellement tous les éléments connus, mais également des alliages. Lorsque l'on souhaite procéder au dépôt en continu d'une couche métallique sur un substrat en défilement, se pose alors le problème de l'alimentation de l'enceinte de dépôt en métal à déposer.

On connaît un premier type d'installations de revêtement dans lequel le métal à déposer est maintenu sous forme liquide par fusion dans un four puis est acheminé vers la zone de dépôt au moyen d'une pompe par exemple, ou bien encore par le principe du baromètre. Ce type d'installation n'est cependant pas adapté au dépôt d'éléments métalliques qui se subliment, c'est à dire qui passent directement de la phase solide à la phase gazeuse.

On connaît également un second type d'installations de revêtement dans lequel le métal à déposer est sous forme solide, comme par exemple sous forme de fils que l'on introduit de façon régulière, ou bien encore sous forme de granules que l'on place à l'intérieur d'un creuset inerte en graphite.

On connaît le brevet US5230923 qui décrit un troisième type d'installation de revêtement en continu. Dans ce brevet, on dépose un revêtement de monoxyde de silicium sur un film plastique par évaporation sous vide par effet joule. L'installation comprend un dispositif d'alimentation en continu de la matière à déposer.

Ces installations permettent le dépôt d'éléments métalliques qui se subliment, mais le procédé de dépôt présentent des instabilités générant des épaisseurs de revêtement non homogènes au cours du temps, ainsi qu'une limitation de la puissance de chauffage, qui ne permet pas d'atteindre des vitesses de dépôt suffisantes.

Le but de la présente invention est donc de remédier aux inconvénients des procédés de l'art antérieur en mettant à disposition un procédé de fabrication d'un substrat en défilement par un métal ou un alliage métallique sublimable qui permette un fonctionnement stable dans le temps à une vitesse de dépôt élevée.

A cet effet, un premier objet de la présente invention est constitué par un procédé de revêtement d'au moins une face d'un substrat en défilement, par évaporation sous vide par plasma d'une couche de métal ou d'alliage métallique susceptible d'être sublimé, selon lequel ledit métal ou alliage métallique est disposé en regard de ladite face du substrat sous la forme d'au moins deux lingots placés en contact l'un avec l'autre, la surface desdits lingots tournée vers ladite face du substrat étant maintenue parallèle au substrat et à une distance constante de celui-ci, au cours du revêtement lesdits lingots étant déplacés simultanément, de façon continue ou séquentielle, par translation, la surface des lingots opposée à celle tournée vers le substrat étant en contact avec un plan incliné, afin de maintenir leurs surfaces tournées vers le substrat parallèles et à distance constante de celui-ci.

Le procédé selon l'invention peut également comprendre différentes caractéristiques, prises seules ou en combinaison :
- les lingots peuvent être déplacés simultanément par translation dans un plan parallèle au plan de défilement du substrat et dans une direction perpendiculaire à la direction de défilement du substrat, la surface des lingots opposée à celle tournée vers le substrat étant en contact avec un plan incliné,
- les lingots peuvent être déplacés simultanément par translation dans un plan parallèle au plan de défilement du substrat et dans une direction parallèle à la direction de défilement du substrat, la surface des lingots opposée à celle tournée vers le substrat étant en contact avec un plan incliné,
- le substrat peut défiler en position verticale, les lingots étant empilés l'un sur l'autre,
- on peut revêtir le substrat sur ses deux faces par évaporation sous vide d'une couche de métal ou d'alliage métallique susceptible d'être sublimé, le métal ou alliage métallique étant disposé en regard de chaque face du substrat sous la forme d'au moins deux lingots placés en contact l'un avec l'autre, la surface des lingots tournée vers chaque face du substrat étant maintenue parallèle et à distance constante de la face du substrat, au cours du revêtement,
- le métal ou alliage métallique peut être identique ou différent pour chaque face du substrat,
- le procédé d'évaporation sous vide peut être un procédé de dépôt par évaporation, tel qu'un dépôt par évaporation par plasma auto-induit (SIP).
- le métal ou alliage métallique peut être choisi parmi le zinc, le magnésium, le chromé, le manganèse, le silicium et leurs alliages et est de préférence du magnésium ou un de ses alliages,
- le dépôt par évaporation sous vide peut être effectué dans une atmosphère réactive,
- le substrat en défilement peut être une bande d'acier, éventuellement déjà revêtue au préalable et de préférence, une bande d'acier préalablement revêtue de zinc ou d'alliage de zinc et sur laquelle on dépose une couche de magnésium ou d'alliage de magnésium.

Un second objet de l'invention est constitué par une installation de revêtement en continu d'un substrat S sur au moins une de ses faces par une couche d'un métal ou d'un alliage métallique susceptible d'être sublimé, comprenant une enceinte sous vide contenant :
- un dispositif de revêtement par évaporation sous vide par plasma,
- des moyens de défilement dudit substrat S au sein du dispositif de revêtement,
- un dispositif d'alimentation 1, 11, 21 en métal ou alliage métallique du dispositif de revêtement, ledit métal ou alliage métallique se présentant sous la forme de lingots L1, ..., Ln, L'1, ..., L'n et comprenant :
   a. des moyens permettant de maintenir les lingots L1, ..., Ln, L'1, ..., L'n en contact les uns avec les autres et de maintenir la surface des lingots L1, ..., Ln, L'1, ..., L'n tournée vers la face à revêtir du substrat S, parallèle et à distance constante du substrat S
   b. des moyens permettant de déplacer simultanément les lingots L1 ..., Ln, L'1, ..., L'n de façon séquentielle ou continue afin de maintenir leurs surfaces tournées vers le substrat S parallèles et à distance constante de celui-ci et
   c. au moins un plan incliné 2, 2' avec lequel les lingots L1, ..., Ln, L'1, ..., L'n sont en contact par leur face opposée à celle tournée vers le substrat S, les moyens de déplacement des lingots L1, ..., Ln, L'1, ..., L'n permettant de les déplacer par translation dans un plan parallèle au plan de défilement du substrat S et dans une direction perpendiculaire à la direction de défilement du substrat S et le plan incliné 2, 2' présentant une inclinaison augmentant dans la direction de déplacement des lingots L1, ..., Ln, L'1, ..., L'n.

L'installation selon l'invention peut également comprendre les variantes suivantes, prises isolément ou en combinaison :
- lesdits lingots peuvent être déplacés dans une direction perpendiculaire à la direction de défilement du substrat S
- les moyens de déplacement des lingots L1, ..., Ln, L'1, ..., L'n peuvent être constitués par au moins un piston 3, 3' agissant sur un premier lingot L1, L'1 en contact avec une première extrémité du plan incliné 2, 2', et s'étendant transversalement par rapport au substrat S, le premier lingot L1, L'1 agissant à son tour sur les lingots L2, .... Ln, L'2, ..., L'n le précédant sur ledit plan incliné 2, 2' jusqu'à sa seconde extrémité,
- l'installation peut comprendre un premier plan incliné 2 muni de lingots L1, ..., Ln et d'un premier piston 3 agissant sur le premier lingot L1 en contact avec la première extrémité du premier plan incliné 2 et un second plan 2' incliné muni de lingots L'1, ..., L'n et d'un second piston 3' agissant sur le premier lingot L'1 en contact avec la première extrémité du second plan incliné 3', lesdits pistons 3, 3' pouvant agir dans la même direction ou dans des directions contraires,
- l'installation peut comprendre deux bacs 4 de récupération par gravité des lingots usagés U, placés sous chaque seconde extrémité des plans inclinés 2, 2',
- lesdits lingots peuvent être déplacés dans une direction parallèle à la direction de défilement du substrat S
- les moyens de déplacement des lingots L1, ..., Ln peuvent être constitués par au moins un piston 13, 23 agissant sur un premier lingot L1 en contact avec une première extrémité du plan incliné 12, 22, et s'étendant longitudinalement par rapport au substrat S, le premier lingot L1 agissant à son tour sur les lingots L2, ..., Ln le précédant sur le plan incliné 12, 22 jusqu'à sa seconde extrémité,
- l'installation peut comprendre un bac de récupération par gravité des lingots usagés, placé sous la seconde extrémité du plan incliné 12, 22,
- le substrat S peut défiler en position verticale, le dispositif d'alimentation 21 comprenant au moins une plaque verticale 24 sur laquelle sont empilés les lingots L1, ..., Ln et qui est en contact avec au moins un piston vertical 23 en position verticale,
- l'installation peut comprendre un dispositif d'alimentation 1, 11, 21 en regard de chaque face du substrat S, chaque dispositif d'alimentation 1, 11, 21 pouvant contenir un métal ou un alliage métallique identique ou différent, ainsi qu'un dispositif d'évaporation sous vide en regard de chaque face du substrat S, l'ensemble étant placé au sein d'une même enceinte sous vide,
- l'installation peut comprendre des moyens d'introduction d'une atmosphère réactive au sein de l'enceinte sous vide,
- le ou les dispositifs d'évaporation sous vide peuvent être des dispositifs de dépôt par évaporation tel qu'un dispositif de dépôt par évaporation par plasma auto-induit (SIP),
- les lingots L1, ..., Ln, L'1, ..., L'n de métal ou d'alliage métallique peuvent être choisis parmi le zinc, magnésium, le chrome, le manganèse et le silicium ou leurs alliages.

Un troisième objet de l'invention est constitué par un dispositif d'alimentation 1, 11, 21 en métal ou alliage métallique d'une installation de dépôt par revêtement sous vide, tel que défini ci-dessus.

D'autres caractéristiques et avantages de l'invention apparaîtront à la lecture de la description qui va suivre, donnée uniquement à titre d'exemple, en référence aux schémas annexés qui représentent :
- -figure 1 : vue en coupe d'un lingot métallique mis en oeuvre par un procédé selon l'art antérieur,
- figure 2 : vue en perspective d'un premier mode de réalisation d'une installation selon l'invention,
- figure 3 : vue en perspective d'un deuxième mode de réalisation d'une installation selon l'invention,
- figure 4 : vue en perspective d'un troisième mode de réalisation d'une installation selon l'invention.

Dans le cadre de la présente invention, on entend par procédé d'évaporation, tout procédé de dépôt par évaporation sous pression réduite par rapport à la pression atmosphérique. L'évaporation sera de préférence effectuée par le procédé SIP (self-induced plasma) dans lequel on combine évaporation sous vide et sputtering magnétron.

Ce procédé consiste à créer un plasma entre un substrat et un creuset contenant la matière à déposer, dans un gaz permettant de générer des radicaux et/ou ions. Ces ions vont, dans les conditions normales de fonctionnement, être accélérés vers la surface de la matière à déposer sur le substrat, et venir arracher des atomes superficiels qui se déposent ensuite sur le substrat. Dans le même temps, le bombardement des ions créés dans le plasma génère un échauffement de la matière à déposer permettant d'ajouter un processus d'évaporation en plus de la pulvérisation magnétron. On pourra notamment se référer au brevet EP 780 486 pour plus de précisions sur la mise en oeuvre de ce procédé.

Le substrat à revêtir se déplace dans une chambre sous vide en regard du creuset contenant la matière à déposer. Ce dernier est polarisé négativement par rapport au substrat, lui-même préférentiellement relié à la masse. Un ensemble d'aimants positionné à l'arrière du creuset confine le plasma créé auprès de celui-ci. Afin de positionner de façon très précise le substrat à revêtir par rapport au creuset, le substrat est généralement disposé sur un rouleau d'appui qui peut être mis en rotation autour de son axe. Ce type de rouleau n'est cependant pas nécessaire lorsque l'on traite des substrats sous forme de plaques rigides, telles que des tôles métalliques épaisses ou des plaques de verre.

Le procédé selon l'invention consiste donc à procéder au dépôt d'une couche métallique ou d'alliage métallique sur un substrat en défilement.

Il s'applique plus particulièrement, mais pas uniquement, au traitement de bandes d'acier, de préférence revêtues de zinc ou d'alliage de zinc. Par alliage de zinc, on désigne tout composé comprenant au moins 50% de zinc et pouvant contenir, par exemple, de l'aluminium, du fer, du silicium etc...

L'obtention de ce revêtement préalable pourra être fait par tout procédé connu de galvanisation, qu'il s'agisse de galvanisation au trempé à chaud, d'électrodéposition ou de dépôt par évaporation sous vide, par exemple. On préférera cependant les procédés de dépôt sous vide.

Le revêtement déposé dans le cadre de la présente invention est un revêtement métallique à base d'éléments susceptibles d'être sublimés lors de leur dépôt par évaporation sous vide. Cela recouvre en particulier des éléments tels que le zinc, le magnésium, le chrome, le manganèse et le silicium, à titre indicatif. On préfère en particulier déposer du magnésium sur une bande préalablement recouverte de zinc, à la suite de quoi on peut procéder à un traitement de diffusion par tout moyen approprié, afin d'obtenir en final un revêtement de Zn-Mg, présentant notamment des performances élevées en matière de résistance à la corrosion.

Les présents inventeurs ont tout d'abord procédé à des essais d'évaporation d'un lingot de magnésium massif et statique placé en regard d'une bande d'acier en défilement au sein d'une installation de dépôt sous vide par le procédé SIP.

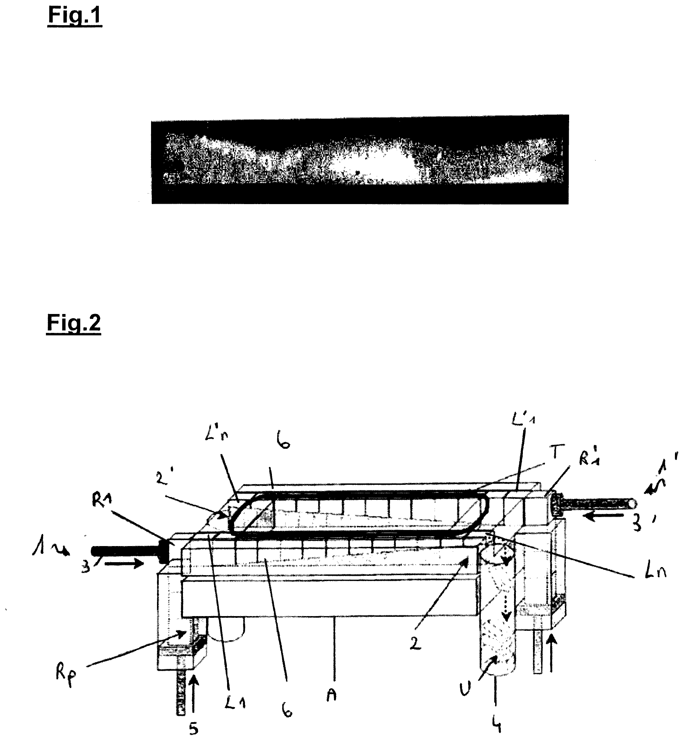

Au bout d'un certain temps d'exploitation, on observe que le dépôt ne présente pas une épaisseur homogène et que la vitesse de dépôt est relativement faible. Il a donc fallu interrompre le dépôt et il a été possible d'observer l'état du lingot, dont une représentation est reproduite en figure 1.

On peut constater que l'usure du lingot est très irrégulière et particulièrement accentuée au droit de la zone de fort champ magnétique. Sans vouloir être liés par une théorie, les présents inventeurs estiment que l'instabilité du procédé de dépôt est directement liée à l'irrégularité de l'usure du lingot.

Afin de stabiliser le procédé, les inventeurs ont donc divisé le lingot massif en au moins deux lingots et ont maintenu les faces supérieures de ces lingots parallèles et à distance constante du substrat à revêtir, en compensant de façon continue ou séquentielle l'usure due à l'évaporation.

A cet effet, une première installation de revêtement selon l'invention, par le procédé SIP, a été mise au point et est partiellement reproduite en figure 2, sur laquelle on peut voir un dispositif d'alimentation 1.

Celui-ci est placé sous le substrat à revêtir (non représenté) qui défile horizontalement, au-dessus du système d'aimants A de confinement du champ magnétique, qui sont placés dans une boîte à eau. Une contre-électrode (non représentée) est placée sous le dispositif d'alimentation 1 et un plasma est créé par décharge entre l'ensemble contre-électrode/aimants et la bande d'acier. Pour faciliter la compréhension, on a représente la zone d'érosion préférentielle au moyen d'un circuit T qui représente la zone de champ magnétique intense.

Le dispositif d'alimentation 1 comprend un premier plan incliné 2 dont l'inclinaison augmente de la gauche vers la droite. Ce plan incliné pourra être réalisé en tout matériau approprié, du moment que celui-ci n'est pas susceptible d'être pulvérisé lors de l'opération, ce qui viendrait polluer le revêtement obtenu. On pourra par exemple réaliser ce premier plan incliné 2 en tungstène.

Sur ce plan incliné 2, sont disposés une série de n lingots L1 à Ln, en contact les uns avec les autres et dont la hauteur va en décroissant de la gauche vers la droite. L'inclinaison du plan incliné 2 est adaptée pour compenser l'usure des lingots L1 à Ln, de telle sorte que les faces supérieures des lingots L1 à Ln restent parallèles entre elles et parallèles au substrat à revêtir qui défile au-dessus du dispositif 1, perpendiculairement au plan incliné 2. On maintient ainsi une distance constante entre les aimants et la face supérieure des lingots, ainsi qu'une distance constante entre la face supérieure des lingots et la face du substrat à revêtir. En effet, pour obtenir un plasma le plus homogène possible, il est important que la distance entre électrodes (constituées ici par les lingots d'une part et par le substrat d'autre part) soit la plus constante possible. Il est en outre tout aussi important que la distance entre les aimants du magnétron et la face supérieure des lingots reste constante. Si on ne respecte pas ces conditions du fait de la consommation des lingots et ce, en un point quelconque de leur face supérieure, le plasma se trouvera intensifié ou diminué localement, engendrant des instabilités de ce plasma et partant, des instabilités dans l'évaporation.

L'utilisation d'un plan incliné 2 permet ainsi d'obtenir un plasma très stable en tout point de la zone d'évaporation.

De part et d'autre des lingots L1 à Ln, sont prévues deux guides latéraux 6 en tungstène qui maintiennent ces lingots L1 à Ln bien alignés.

A la gauche du premier lingot L1 est placé un piston 3 qui agit sur ce premier lingot L1 pour le déplacer en translation vers la droite, tout en étant guidé par le plan incliné 2 et le guide latéral 6. Le mouvement du lingot L1 déplace en cascade tous les lingots posés sur le plan incliné 2, jusqu'à ce que le lingot d'extrémité Ln tombe par gravité dans un bac de récupération 4 qui permet de réceptionner les lingots usagés qui pourront être fondus et réutilisés.

Lorsque l'extrémité du piston 3 arrive au niveau de la première extrémité du plan incliné 2, il est alors en bout de course et est actionné dans le sens inverse. Dans un second temps, un piston vertical 5 agissant sur une platine portant une série de p lingots neufs R1 à Rp, est actionné vers le haut, de façon à présenter un nouveau lingot à hauteur de la première extrémité du plan incliné 2. Le piston 3 est alors mis en contact avec la face latérale du lingot R1 qui est poussé contre le premier lingot L1 en contact avec le plan incliné 2.

On voit donc que l'on peut alimenter en lingots le dispositif, de façon continue, sans interruption du procédé et en maintenant la surface des lingots en exploitation à la fois plane et parallèle au substrat à revêtir grâce au plan incliné 2 et au mouvement régulier imprimé par le piston 3.

Afin de couvrir la majeure partie de la zone de champ magnétique intense T et donc d'optimiser la vitesse de dépôt, on a placé un second dispositif d'alimentation 1' en tous points identique au dispositif 1, au regard de le seconde moitié de la zone T. Le piston 3' déplace ici la seconde série de n lingots L'1 à L'n de la droite vers la gauche, le plan incliné 2' étant orienté de façon opposé au plan incliné 2, mais il serait tout à fait possible de prévoir deux dispositifs d'alimentation identiques en tous points pour chaque moitié de la zone T.

On constate que dans ce mode de réalisation, il est possible d'optimiser la taille des lingots en déterminant leur largeur en fonction de la largeur de la zone T.

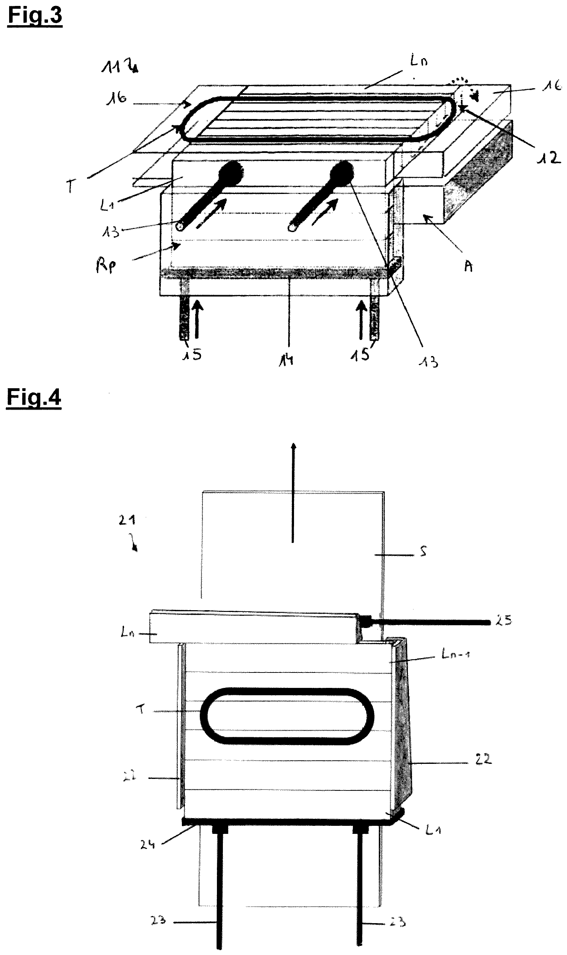

Dans un deuxième mode de réalisation, tel que représenté en figure 3, on peut voir un dispositif d'alimentation 11, comprenant de façon similaire au premier mode de réalisation, un plan incliné 12 portant une série de n lingots L1 à Ln s'étendant transversalement par rapport au substrat en défilement dans un plan horizontal (non représenté). L'environnement du dispositif d'alimentation 11 est identique à celui décrit pour la figure 2.

Le lingot L1 est déplacé par l'action des pistons 13 qui permettent de faire avancer les lingots L1 à Ln sur le plan incliné 12 jusqu'à tomber par gravité dans un bac de récupération (non représenté) placé sous la seconde extrémité du plan incliné 12.

Le rechargement en lingots se fait par une plaque 14 mise en mouvement par deux pistons 15, qui supporte un empilement de p lingots R1 à Rp et fonctionne de la même manière que le dispositif correspondant de la figure 2. De part et d'autre des lingots L1 à Ln, sont prévues deux guides latéraux 16 en tungstène qui maintiennent ces lingots L1 à Ln bien alignés.

On constate également que ce mode de réalisation de l'installation selon l'invention permet de s'adapter facilement à différentes largeurs de substrat à revêtir. En effet, il suffit de modifier la largeur des lingots et l'écartement des pièces 16 pour obtenir un dispositif présentant la largeur exactement nécessaire au revêtement en cours.

Dans un troisième mode de réalisation, tel que représenté en figure 4, on peut voir un dispositif d'alimentation 21, comprenant de façon similaire au premier mode de réalisation, deux plans inclinés 22 portant une série de n lingots L1 à Ln s'étendant transversalement par rapport au substrat S en défilement dans un plan vertical. Ces plans inclinés 22 présentent en outre des joues latérales assurant un bon alignement des lingots.

Le lingot L1 est déplacé par l'action de deux pistons verticaux 23 sur une plaque verticale 24, ce qui permet de faire avancer les lingots L1 à Ln le long des plans inclinés 22.

Lorsque le lingot supérieur Ln arrive au-delà de l'extrémité des plans inclinés 22, un piston horizontal 25 est actionné latéralement contre la face de ce lingot, qui peut ainsi être évacué sur le côté.

Ce mode de réalisation permet de revêtir le substrat de façon aisée en position verticale. Cette position permet en outre de réaliser très facilement un revêtement biface en plaçant un dispositif d'alimentation selon l'invention de chaque côté du substrat, le tout étant placé au sein d'une même enceinte à pression réduite.

### Essais

Des essais ont été réalisés à partir d'un montage conforme au premier mode de réalisation et d'un dispositif d'évaporation par plasma auto-induit (SIP). Des lingots de zinc pur ou de magnésium pur d'une épaisseur de 4 cm et d'une largeur de 10 cm ont été utilisés pour revêtir des bandes d'acier dont la largeur a varié entre 50 et 200 cm. Les bandes d'acier défilaient à 100 m/min sur un rouleau d'appui. On a également fait varier la vitesse d'évaporation des lingots.

La distance entre la surface supérieure des lingots et les bandes d'acier à revêtir a été maintenue à 5 cm et l'ouverture de la chambre, correspondant à la zone de dépôt dans le sens de défilement de la bande, a été réglée à 40 cm. Dans tous les essais réalisés, on a déterminé la vitesse de défilement des lingots qu'il faut atteindre pour obtenir une épaisseur de dépôt de l'ordre de 1,5 µm

Les résultats sont rassemblés dans les trois tableaux suivants :

| Matériau de revêtement | Zn | | | |
|---|---|---|---|---|
| Largeur bande (cm) | 50 | 100 | 150 | 200 |
| Largeur module SIP (cm) | 70 | 120 | 170 | 220 |
| Vitesse évaporation (g/cm2/s) | 0,01 | 0,01 | 0,01 | 0,01 |
| Vitesse défilement lingot (cm/min) | 2 | 3,4 | 4,8 | 6,2 |

| Matériau de revêtement | Zn | | | |
|---|---|---|---|---|
| Largeur bande (cm) | 50 | 100 | 150 | 200 |
| Largeur module SIP (cm) | 70 | 120 | 170 | 220 |
| Vitesse évaporation (g/cm2/s) | 0,02 | 0,02 | 0,02 | 0,02 |
| Vitesse défilement lingot (cm/min) | 4 | 6,8 | 9,6 | 12,4 |

| Matériau de revêtement | Mg | | | |
|---|---|---|---|---|
| Largeur bande (cm) | 50 | 100 | 150 | 200 |
| Largeur module SIP (cm) | 70 | 120 | 170 | 220 |
| Vitesse évaporation (g/cm2/s) | 0,002 | 0,002 | 0,002 | 0,002 |
| Vitesse défilement lingot (cm/min) | 1,6 | 2,8 | 4 | 5,2 |

On constate que la vitesse de défilement des lingots dépend essentiellement de la largeur de la bande à revêtir et de la vitesse d'évaporation de la matière de revêtement.

Des résultats analogues ont été obtenus à partir de montages conformes aux deuxième et troisième modes de réalisation.

D'une façon plus générale, on constate qu'une vitesse de défilement des lingots comprise entre 1 et 15 cm/min permet d'atteindre les cibles d'épaisseur de revêtements recherchées. Si l'on souhaite atteindre des épaisseurs de revêtement plus importantes, il suffit alors de faire passer le substrat devant une série de dispositifs de revêtements. Ainsi, pour obtenir une épaisseur de zinc de l'ordre de 7,5 µm dans les conditions d'évaporation indiquées dans les tableaux ci dessus, il faudra cinq dispositifs de revêtement.

Quel que soit le mode de réalisation adopté, l'invention présente également l'avantage de ne pas nécessiter l'usage de creusets en graphite, ce qui permet d'y réaliser facilement des dépôts en atmosphère réactive. Ceci peut notamment permettre de réaliser des dépôts d'oxydes, de nitrures, de sulfures, de fluorures métalliques, par exemple, et ceci à des vitesses de dépôt élevées.

Comme on a pu le voir au fil des descriptions de quelques modes de réalisation préférés de l'invention, le revêtement peut notamment être effectué lorsque le substrat défile de façon horizontale ou verticale. Il va de soi que le revêtement peut également être effectué pour toute position du substrat qui serait intermédiaire entre l'horizontale et la verticale.

## Revendications

1. Procédé de revêtement d'au moins une face d'un substrat en défilement, par évaporation sous vide par plasma d'une couche de métal ou d'alliage métallique susceptible d'être sublimé, selon lequel ledit métal ou alliage métallique est disposé en regard de ladite face du substrat sous la forme d'au moins deux lingots placés en contact l'un avec l'autre, la surface desdits lingots tournée vers ladite face du substrat étant maintenue parallèle au substrat et à une distance constante de celui-ci, au cours du revêtement, lesdits lingots étant déplacés simultanément, de façon continue ou séquentielle, par translation, la surface des lingots opposée à celle tournée vers le substrat étant en contact avec un plan incliné, afin de maintenir leurs surfaces tournées vers le substrat parallèles et à distance constante de celui-ci.

2. Procédé de revêtement selon la revendication 1, dans lequel lesdits lingots sont déplacés simultanément par translation dans un plan parallèle au plan de défilement du substrat et dans une direction perpendiculaire à la direction de défilement du substrat, la surface des lingots opposée à celle tournée vers le substrat étant en contact avec ledit plan incliné.

3. Procédé de revêtement selon la revendication 1, dans lequel lesdits lingots sont déplacés simultanément par translation dans un plan parallèle au plan de défilement du substrat et dans une direction parallèle à la direction de défilement du substrat, la surface des lingots opposée à celle tournée vers le substrat étant en contact avec ledit plan incliné.

4. Procédé de revêtement selon l'une quelconque des revendications 1 à 3, dans lequel ledit substrat défile en position verticale, lesdits lingots étant empilés l'un sur l'autre.

5. Procédé de revêtement selon l'une quelconque des revendications 1 à 4, dans lequel on revêt ledit substrat sur ses deux faces par évaporation sous vide d'une couche de métal ou d'alliage métallique susceptible d'être sublimé, ledit métal ou alliage métallique étant disposé en regard de chaque face du substrat sous la forme d'au moins deux lingots placés en contact l'un avec l'autre, la surface desdits lingots tournée vers chaque face du substrat étant maintenue parallèle et à distance constante de ladite face du substrat, au cours du revêtement.

6. Procédé de revêtement selon la revendication 5, dans lequel ledit métal ou alliage métallique est identique pour chaque face du substrat.

7. Procédé de revêtement selon la revendication 5, dans lequel ledit métal ou alliage métallique est différent pour chaque face du substrat.

8. Procédé de revêtement selon l'une quelconque des revendications 1 à 7, dans lequel ledit métal ou alliage métallique est choisi parmi le zinc, le magnésium, le chrome, le manganèse, le silicium et leurs alliages.

9. Procédé selon la revendication 8, dans lequel ledit métal ou alliage métallique est le magnésium ou ses alliages.

10. Procédé selon l'une quelconque des revendications 1 à 9, dans lequel le dépôt par évaporation sous vide peut être effectué dans une atmosphère réactive.

11. Procédé selon l'une quelconque des revendications 1 à 10, dans lequel le substrat en défilement est une bande d'acier, éventuellement déjà revêtue au préalable.

12. Procédé selon la revendication 11, dans lequel le substrat en défilement est une bande d'acier préalablement revêtue de zinc ou d'alliage de zinc et sur laquelle on dépose une couche de magnésium ou d'alliage de magnésium.

13. Installation de revêtement en continu d'un substrat (S) sur au moins une de ses faces par une couche d'un métal ou d'un alliage métallique susceptible d'être sublimé, comprenant une enceinte sous vide contenant :
- un dispositif de revêtement par évaporation sous vide par plasma,
- des moyens de défilement dudit substrat (S) au sein du dispositif de revêtement,
- un dispositif d'alimentation (1, 11, 21) en métal ou alliage métallique du dispositif de revêtement, ledit métal ou alliage métallique se présentant sous la forme de lingots (L1, ..., Ln, L'1, ..., L'n) et comprenant :
a. des moyens permettant de maintenir lesdits lingots (L1, ..., Ln, L'1, ..., L'n) en contact les uns avec les autres et de maintenir la surface desdits lingots (L1, ..., Ln, L'1, ..., L'n) tournée vers la face à revêtir du substrat (S), parallèle et à distance constante dudit substrat (S),
b. des moyens permettant de déplacer simultanément lesdits lingots (L1, ..., Ln, L'1, ..., L'n) de façon séquentielle ou continue afin de maintenir leurs surfaces tournées vers le substrat (S) parallèles et à distance constante de celui-ci et
c. au moins un plan incliné (2, 2') avec lequel lesdits lingots (L1, ..., Ln, L'1, ..., L'n) sont en contact par leur face opposée à celle tournée vers ledit substrat (S), lesdits moyens de déplacement des lingots (L1, ..., Ln, L'1, .... L'n) permettant de les déplacer par translation dans un plan parallèle au plan de défilement du substrat (S) et ledit plan incliné (2 , 2' ; 12, 22) présentant une inclinaison augmentant dans la direction de déplacement desdits lingots (L1,..., Ln, L'1,..., L'n).

14. Installation selon la revendication 13, dans laquelle lesdits lingots sont déplacés dans une direction perpendiculaire à la direction de défilement du substrat (S).

15. Installation selon la revendication 14, dans laquelle lesdits moyens de déplacement des lingots (L1, ..., Ln, L'1, ..., L'n) sont constitués par au moins un piston (3, 3') agissant sur un premier lingot (L1, L'1) en contact avec une première extrémité dudit plan incliné (2, 2'), et s'étendant transversalement par rapport au substrat (S), ledit premier lingot (L1, L'1) agissant à son tour sur les lingots (L2, ..., Ln, L'2, ..., L'n) le précédant sur ledit plan incliné (2, 2') jusqu'à sa seconde extrémité.

16. lnstallation selon la revendication 15, comprenant un premier plan incliné (2) muni de lingots (L1, ..., Ln) et d'un premier piston (3) agissant sur le premier lingot (L1) en contact avec la première extrémité dudit premier plan incliné (2) et un second plan (2') incliné muni de lingots (L'1, ..., L'n) et d'un second piston (3') agissant sur le premier lingot (L'1) en contact avec la première extrémité dudit second plan incliné (3'), lesdits pistons (3, 3') pouvant agir dans la même direction ou dans des directions contraires.

17. Installation selon la revendication 16, comprenant deux bacs (4) de récupération par gravité des lingots usagés (U), placés sous chaque seconde extrémité desdits plans inclinés (2, 2').

18. Installation selon la revendication 13, dans laquelle lesdits lingots sont déplacés dans une direction parallèle à la direction de défilement du substrat (S).

19. Installation selon la revendication 18, dans laquelle lesdits moyens de déplacement des lingots (L1, ..., Ln) sont constitués par au moins un piston (13, 23) agissant sur un premier lingot (L1) en contact avec une première extrémité dudit plan incliné (12, 22), et s'étendant longitudinalement par rapport au substrat (S), ledit premier lingot (L1) agissant à son tour sur les lingots (L2, ..., Ln) le précédant sur ledit plan incliné (12, 22) jusqu'à sa seconde extrémité.

20. Installation selon la revendication 19, comprenant un bac de récupération par gravité des lingots usagés, placé sous ladite seconde extrémité du plan incliné (12, 22).

21. Installation selon l'une quelconque des revendications 18 à 20, dans laquelle le substrat (S) défile en position verticale, ledit dispositif d'alimentation (21) comprenant au moins une plaque verticale (24) sur laquelle sont empilés lesdits lingots (L1, ..., Ln) et qui est en contact avec au moins un piston vertical (23).

22. Installation selon l'une quelconque des revendications 13 à 21, comprenant un dispositif d'alimentation (1, 11, 21) en regard de chaque face dudit substrat (S), chaque dispositif d'alimentation (1, 11, 21) pouvant contenir un métal ou un alliage métallique identique ou différent, ainsi qu'un dispositif d'évaporation sous vide en regard de chaque face dudit substrat (S), l'ensemble étant placé au sein d'une même enceinte sous vide.

23. Installation selon l'une quelconque des revendications 13 à 22, comprenant des moyens d'introduction d'une atmosphère réactive au sein de ladite enceinte sous vide.

24. Installation selon l'une quelconque des revendications 13 à 23, dans laquelle lesdits lingots (L1, ..., Ln, L'1, ..., L'n) de métal ou d'alliage métallique sont choisis parmi le zinc, le magnésium, le chrome, le manganèse et le silicium ou leurs alliages.

25. Dispositif d'alimentation (1, 11, 21) en métal ou alliage métallique d'une installation de dépôt par revêtement sous vide, tel que défini dans l'une quelconque des revendications 13 à 24.

## Patentansprüche

1. Verfahren zum Beschichten wenigstens einer Fläche eines sich vorbeibewegenden Substrats mit einer Schicht aus einem Metall oder Metalllegierung, das bzw. die sublimationsfähig ist, durch Plasma-Vakuumverdampfung, wobei das Metall oder die Metalllegierung gegenüber der Fläche des Substrats in Form wenigstens zweier Blöcke angeordnet wird, die miteinander in Kontakt sind, wobei die Oberfläche der Blöcke, die zu der Fläche des Substrats zeigt, während der Beschichtung parallel zu dem Substrat und in einem konstanten Abstand hiervon gehalten wird, wobei die Blöcke gleichzeitig auf ununterbrochene oder aufeinander folgende Weise translatorisch verlagert werden, wobei die Oberfläche der Blöcke gegenüber jener, die zu dem Substrat zeigt, mit einer geneigten Ebene in Kontakt ist, um ihre zu dem Substrat zeigenden Oberflächen parallel und in einem konstanten Abstand zu diesem zu halten.

2. Beschichtungsverfahren nach Anspruch 1, wobei die Blöcke in einer Ebene parallel zu der Vorbeibewegungsebene des Substrats und in einer Richtung senkrecht zu der Vorbeibewegungsrichtung des Substrats gleichzeitig translatorisch verlagert werden, wobei die Oberfläche der Blöcke gegenüber jener, die zu dem Substrat zeigt, mit der geneigten Ebene in Kontakt ist.

3. Beschichtungsverfahren nach Anspruch 1, wobei die Blöcke in einer Ebene parallel zu der Vorbeibewegungsebene des Substrats und in einer Richtung parallel zu der Vorbeibewegungsrichtung des Substrats gleichzeitig translatorisch verlagert werden, wobei die Oberfläche der Blöcke gegenüber jener, die zu dem Substrat zeigt, mit der geneigten Ebene in Kontakt ist.

4. Beschichtungsverfahren nach einem der Ansprüche 1 bis 3, wobei sich das Substrat in einer vertikalen Stellung vorbeibewegt, wobei die Blöcke übereinander gestapelt sind.

5. Beschichtungsverfahren nach einem der Ansprüche 1 bis 4, wobei das Substrat auf seinen beiden Flächen durch Vakuumverdampfung mit einer Schicht aus einem Metall oder einer Metalllegierung, die sublimationsfähig ist, beschichtet wird, wobei das Metall oder die Metalllegierung gegenüber jeder Fläche des Substrats in Form wenigstens zweier Blöcke, die miteinander in Kontakt sind, angeordnet ist, wobei die Oberfläche der Blöcke, die zu jeder Fläche des Substrats zeigt, während der Beschichtung parallel zu der Fläche des Substrats und in einem konstanten Abstand hiervon gehalten wird.

6. Beschichtungsverfahren nach Anspruch 5, wobei das Metall oder die Metalllegierung für jede Fläche des Substrats gleich ist.

7. Beschichtungsverfahren nach Anspruch 5, wobei das Metall oder die Metalllegierung für jede Fläche des Substrats unterschiedlich ist.

8. Beschichtungsverfahren nach einem der Ansprüche 1 bis 7, wobei das Metall oder die Metalllegierung aus Zink, Magnesium, Chrom, Mangan, Silicium oder ihren Legierungen gewählt ist.

9. Verfahren nach Anspruch 8, wobei das Metall oder die Metalllegierung Magnesium bzw. eine seiner Legierungen ist.

10. Verfahren nach einem der Ansprüche 1 bis 9, wobei die Abscheidung durch Vakuumverdampfung in einer reaktiven Atmosphäre ausgeführt werden kann.

11. Verfahren nach einem der Ansprüche 1 bis 10, wobei das sich vorbeibewegende Substrat ein Stahlband ist, das eventuell bereits im Voraus beschichtet worden ist.

12. Verfahren nach Anspruch 11, wobei das sich vorbeibewegende Substrat ein Stahlband ist, das im Voraus mit Zink oder einer Zinklegierung beschichtet worden ist und auf dem eine Schicht aus Magnesium oder einer Magnesiumlegierung abgelagert wird.

13. Anlage zum ununterbrochenen Beschichten eines Substrats (S) auf wenigstens einer seiner Flächen mit einer Schicht aus Metall oder einer Metalllegierung, das bzw. die sublimationsfähig ist, die einen Vakuumbehälter umfasst, der Folgendes enthält:
- eine Vorrichtung zum Beschichten durch Plasma-Vakuumverdampfung,
- Mittel zum Vorbeibewegen des Substrats (S) in der Beschichtungsvorrichtung ,
- eine Vorrichtung (1, 11, 21) für die Beschickung mit Metall oder einer Metalllegierung der Beschichtungsvorrichtung, wobei das Metall oder die Metalllegierung die Form von Blöcken (L1, ..., Ln, L'1, ..., L'n) aufweist, und die Folgendes umfasst:
a. Mittel, die ermöglichen, die Blöcke (L1, ..., Ln, L'1, ..., L'n) in gegenseitigem Kontakt zu halten und die Oberfläche der Blöcke (L1, ..., Ln, L'1, ..., L'n) gerichtet zu der zu beschichtenden Fläche des Substrats (S), die zu dem Substrat (S) parallel ist und hierzu einen konstanten Abstand aufweist, zu halten,
b. Mittel, die ermöglichen, die Blöcke (L1, ..., Ln, L'1, ..., L'n) gleichzeitig auf aufeinander folgende oder ununterbrochene Weise zu verlagern, um ihre zu dem Substrat (S) gerichteten Oberflächen parallel und in einem konstanten Abstand hiervon zu halten, und
c. wenigstens eine geneigte Ebene (2, 2'), wobei die Blöcke (L1, ..., Ln, L'1, ..., L'n) mit ihrer Fläche gegenüber jener, die zu dem Substrat (S) gerichtet ist, damit in Kontakt sind, wobei die Mittel zum Verlagern der Blöcke (L1, ..., Ln, L'1, ..., L'n) ermöglichen, diese in einer Ebene parallel zu der Vorbeibewegungsebene des Substrats (S) translatorisch zu verlagern, und die geneigte Ebene (2, 2'; 12, 22) eine Neigung aufweist, die in der Richtung der Vorbeibewegung der Blöcke (L1, ..., Ln, L'1, ..., L'n) zunimmt.

14. Anlage nach Anspruch 13, wobei die Blöcke in einer Richtung senkrecht zu der Vorbeibewegungsrichtung des Substrats (S) verlagert werden.

15. Anlage nach Anspruch 14, wobei die Mittel zum Verlagern der Blöcke (L1, ..., Ln, L'1, ..., L'n) durch wenigstens einen Kolben (3, 3') gebildet sind, der auf einen ersten Block (L1, L'1) in Kontakt mit einem ersten Ende der geneigten Ebene (2, 2') einwirkt und sich transversal in Bezug auf das Substrat (S) erstreckt, wobei der erste Block (L1, L'1) seinerseits auf die Blöcke (L2, ..., Ln, L'2, ..., L'n), die ihm auf der geneigten Ebene (2, 2') bis zu seinem zweiten Ende vorhergehen, einwirkt.

16. Anlage nach Anspruch 15, die eine erste geneigte Ebene (2), die mit Blöcken (L1, ..., Ln) und mit einem ersten Kolben (3), der auf den ersten Block (L1) in Kontakt mit dem ersten Ende der ersten geneigten Ebene (2) einwirkt, versehen ist, und eine zweite geneigte Ebene (2'), die mit Blöcken (L'1, ..., L'n) und mit einem zweiten Kolben (3'), der auf den ersten Block (L'1) in Kontakt mit dem ersten Ende der zweiten geneigten Ebene (3') einwirkt, umfasst, wobei die Kolben (3, 3') in derselben Richtung oder in entgegengesetzten Richtungen wirken können.

17. Anlage nach Anspruch 16, die zwei Behälter (4) für die Wiedergewinnung benutzter Blöcke (U) durch die Schwerkraft umfasst, die unter jedem zweiten Ende der geneigten Ebenen (2, 2') angeordnet sind.

18. Anlage nach Anspruch 13, wobei die Blöcke in einer Richtung parallel zu der Vorbeibewegungsrichtung des Substrats (S) verlagert werden.

19. Anlage nach Anspruch 18, wobei die Mittel zum Verlagern der Blöcke (L1, ..., Ln) durch wenigstens einen Kolben (13, 23) gebildet sind, der auf einen ersten Block (L1) in Kontakt mit einem ersten Ende der geneigten Ebene (12, 22) einwirkt und sich longitudinal in Bezug auf das Substrat (S) erstreckt, wobei der erste Block (L1) seinerseits auf die Blöcke (L2, ..., Ln), die ihm auf der geneigten Ebene (12, 22) bis zu seinem zweiten Ende vorhergehen, einwirkt.

20. Anlage nach Anspruch 19, die einen Behälter für die Wiedergewinnung benutzter Blöcke durch die Schwerkraft umfasst, der unter dem zweiten Ende der geneigten Ebene (12, 22) angeordnet ist.

21. Anlage nach einem der Ansprüche 18 bis 20, wobei sich das Substrat (S) in einer vertikalen Stellung vorbeibewegt, wobei die Beschickungsvorrichtung (21) wenigstens eine vertikale Platte (24) aufweist, auf der die Blöcke (L1, ..., Ln) gestapelt sind und die mit wenigstens einem vertikalen Kolben (23) in Kontakt ist.

22. Anlage nach einem der Ansprüche 13 bis 21, die eine Beschickungsvorrichtung (1, 11, 21) gegenüber jeder Fläche des Substrats (S), wobei jede Beschickungsvorrichtung (1, 11, 21) ein Metall oder eine Metalllegierung enthalten kann, die gleich oder unterschiedlich sind, und eine Vakuumverdampfungsvorrichtung gegenüber jeder Fläche des Substrats (S) umfasst, wobei die Gesamtheit im selben Vakuumbehälter angeordnet ist.

23. Anlage nach einem der Ansprüche 13 bis 22, die Mittel zum Einleiten einer reaktiven Atmosphäre in den Vakuumbehälter umfasst.

24. Anlage nach einem der Ansprüche 13 bis 23, wobei die Blöcke (L1, ..., Ln, L'1, ..., L'n) aus einem Metall oder einer Metalllegierung aus Zink, Magnesium, Chrom, Mangan und Silicium bzw. ihren Legierungen gewählt sind.

25. Vorrichtung (1, 11, 21) für die Beschickung einer Anlage für die Abscheidung durch Vakuumbeschichtung, wie in einem der Ansprüche 13 bis 23 definiert, mit einem Metall oder einer Metalllegierung.

## Claims

1. Coating process for coating at least one side of a running substrate, by plasma-enhanced vacuum evaporation, with a layer of a sublimable metal or metal alloy, in which said metal or metal alloy is positioned so as to face said side of the substrate in the form of at least two ingots placed in contact with one another, that surface of said ingots facing said side of the substrate being kept parallel to the substrate and at a constant distance from the latter during coating, said ingots being moved simultaneously, either continuously or sequentially, by translation, the opposite surface of the ingots from that facing the substrate being in contact with an inclined plane, so as to keep their surfaces facing the substrate parallel to and at a constant distance from the latter.

2. Coating process according to Claim 1, in which said ingots are moved simultaneously by translation in a plane parallel to the plane in which the substrate runs and in a direction perpendicular to the direction in which the substrate runs, the opposite surface of the ingots from that facing the substrate being in contact with said inclined plane.

3. Coating process according to Claim 1, in which said ingots are moved simultaneously by translation in a plane parallel to the plane in which the substrate runs and in a direction parallel to the direction in which the substrate runs, the opposite surface of the ingots from that facing the substrate being in contact with said inclined plane.

4. Coating process according to any one of Claims 1 to 3, in which said substrate runs vertically, said ingots being stacked one on top of another.

5. Coating process according to any one of Claims 1 to 4, in which said substrate is coated by vacuum evaporation on both its sides with a layer of a sublimable metal or metal alloy, said metal or metal alloy being positioned so as to face each side of the substrate in the form of at least two ingots placed in contact with one another, that surface of said ingots facing each side of the substrate being kept parallel to and at a constant distance from said side of the substrate during coating.

6. Coating process according to Claim 5, in which said metal or metal alloy is the same for each side of the substrate.

7. Coating process according to Claim 5, in which said metal or metal alloy is different for each side of the substrate.

8. Coating process according to any one of Claims 1 to 7, in which said metal or metal alloy is chosen from zinc, magnesium, chromium, manganese, silicon and alloys thereof.

9. Process according to Claim 8, in which said metal or metal alloy is magnesium or alloys thereof.

10. Process according to any one of Claims 1 to 9, in which the deposition by vacuum evaporation may be carried out in a reactive atmosphere.

11. Process according to any one of Claims 1 to 10, in which the running substrate is a steel strip, possibly already coated beforehand.

12. Process according to Claim 11, in which the running substrate is a steel strip which has been coated beforehand with zinc or a zinc alloy and on which a layer of magnesium or a magnesium alloy is deposited.

13. Coating plant for continuously coating a substrate (S) on at least one of its sides with a layer of a sublimable metal or metal alloy, comprising a vacuum chamber containing:
- a plasma-enhanced vacuum evaporation coater;
- means for making said substrate (S) run through the coater; and
- a feeder (1, 11, 21) for feeding the coater with a metal or metal alloy, said metal or metal alloy being in the form of ingots (L1, ..., Ln, L'1, ..., L'n) and comprising:
a. means for keeping said ingots (L1, ..., Ln, L'1, ..., L'n) in contact with one another and for keeping that surface of said ingots (L1, ..., Ln, L'1, ..., L'n) facing the side of the substrate (S) to be coated parallel to and at a constant distance from said substrate (S),
b. means for simultaneously moving said ingots (L1, ..., Ln, L'1, ..., L'n) sequentially or continuously so as to keep their surfaces facing the substrate (S) parallel to and at a constant distance from the latter, and
c. at least one inclined plane (2, 2') with which said ingots (L1, ..., Ln, L'1, ..., L'n) are in contact via their side opposite that facing said substrate (S), said means for moving the ingots (L1, ..., Ln, L'1, ..., L'n) enabling them to be moved by translation in a plane parallel to the plane in which the substrate (S) runs and the inclination of said inclined plane (2, 2'; 12, 22) increasing in the direction of movement of said ingots (L1, ..., Ln, L'1, ..., L'n).

14. Plant according to Claim 13, in which said ingots are moved in a direction perpendicular to the direction in which the substrate (S) runs.

15. Plant according to Claim 14, in which said means for moving the ingots (L1, ..., Ln, L'1, ..., L'n) consist of at least one piston (3, 3') acting on a first ingot (L1, L'1) in contact with a first end of said inclined plane (2, 2'), and extending transversely relative to the substrate (S), said first ingot (L1, L'1) acting in turn on the ingots (L2, ..., Ln, L'2, ..., L'n) preceding it on said inclined plane (2, 2') as far as its second end.

16. Plant according to Claim 15, having a first inclined plane (2) provided with ingots (L1, ..., Ln) and with a first piston (3) acting on the first ingot (L1) in contact with the first end of said first inclined plane (2) and a second inclined plane (2') provided with ingots (L'1, ..., L'n) and with a second piston (3') acting on the first ingot (L'1) in contact with the first end of said second inclined plane (3'), it being possible for said pistons (3, 3') to act in the same direction or in opposed directions.

17. Plane according to Claim 16, comprising two tanks (4) for recovering, by gravity, the spent ingots (U), said tanks being placed beneath each second end of said inclined planes (2, 2').

18. Plant according to Claim 13, in which said ingots are moved in a direction parallel to the direction in which the substrate (S) runs.

19. Plant according to Claim 18, in which said means for moving the ingots (L1, ..., Ln) consist of at least one piston (13, 23) acting on a first ingot (L1) in contact with a first end of said inclined plane (12, 22), and extending longitudinally relative to the substrate (S), said first ingot (L1) acting in turn on the ingots (L2, ..., Ln) preceding it on said inclined plane (12, 22) as far as its second end.

20. Plant according to Claim 19, comprising a tank for recovering, by gravity, the spent ingots, said tank being placed beneath said second end of the inclined plane (12, 22).

21. Plant according to any one of Claims 18 to 20, in which the substrate (S) runs vertically, said feeder (21) comprising at least one vertical plate (24) on which said ingots (L1, ..., Ln) are stacked, said plate being in contact with at least one vertical piston (23).

22. Plant according to any one of Claims 13 to 21, comprising a feeder (1, 11, 21) facing each side of said substrate (S), it being possible for each feeder (1, 11, 21) to contain an identical or different metal or metal alloy, and a vacuum evaporator facing each side of said substrate (S), the assembly being placed within the same vacuum chamber.

23. Plant according to any one of Claims 13 to 22, comprising means for introducing a reactive atmosphere into said vacuum chamber.

24. Plant according to any one of Claims 13 to 23, in which said ingots (L1, ..., Ln, L'1, ..., L'n) of a metal or metal alloy are chosen from zinc, magnesium, chromium, manganese and silicon or alloys thereof.

25. Feeder (1, 11, 21) for feeding a vacuum coating plant, as defined in any one of Claims 13 to 24, with a metal or metal alloy.
